# EUROPÄISCHE PATENTSCHRIFT

(11) **EP 0 915 191 B1**
(45) Veröffentlichungstag und Bekanntmachung des Hinweises auf die Patenterteilung: **09.03.2005**
(21) Anmeldenummer: 98115131.9
(22) Anmeldetag: 12.08.1998
(51) Int. Cl.: C30B 25/14, C23C 16/44, F16L 21/00

(54) **Vorrichtung zum vakuumdichten Verbinden von zwei Körpern aus unterschiedlichen Materialien**
Apparatus for making a vacuum seal between two bodies made of different materials
Appareillage pour faire un joint à vide entre deux corps en matériaux différents

(30) Priorität: 13.10.1997 DE 19745185
(43) Veröffentlichungstag der Anmeldung: 12.05.1999
(73) Patentinhaber: Unaxis Balzers Aktiengesellschaft, FL-9496 Balzers (LI)
(72) Erfinder: Schulmann, Winfried, 63581 Kleinostheim (DE); Kaiser, Helmut,Dr., 63486 Bruchköbel (DE); Wenske, Udo, 63486 Bruchköbel (DE)

(56) Entgegenhaltungen:
- DE-A- 3 403 317
- DE-A- 3 729 848
- FR-A- 2 275 719
- US-A- 3 151 763
- US-A- 5 368 648
- PATENT ABSTRACTS OF JAPAN vol. 017, no. 201 (M-1399), 20. April 1993 (1993-04-20) & JP 04 347096 A (SEIKO INSTR INC), 2. Dezember 1992 (1992-12-02)

## Beschreibung

Die Erfindung betrifft eine Vorrichtung zum vakuumdichten Verbinden von zwei Körpern, insbesondere einem Quarz- und einem Metallkörper, gemäß dem Oberbegriff des Anspruchs 1 oder des Anspruchs 4 sowie eine Epitaxieanlage, in der die Verbindungsvorrichtung zum Einsatz kommen kann.

Die Erfindung findet beispielsweise in Epitaxieanlagen Anwendung, in der ein Quarzrohr oder der Quarzbehälter zur Aufnahme eines zu beschichtenden Guts, beispielsweise zu beschichtender Wafer, angeordnet ist. Das zu bedampfende Gut wird mittels eines Quarzbootes an einer Seite des Quarzrohrs in dieses über eine vakuumdicht abschließbare Schleuse eingeführt. An der anderen Seite ist das Quarzrohr beispielsweise über ein Metallgehäuse an eine Vakuumpumpeinrichtung vakuumdicht angeschlossen. Da in dem Quarzrohr Temperaturen zwischen 500 und 800°C vorliegen können und dieses ferner unter einem sehr niedrigen Unterdruck (z. B. 10⁻¹⁰ hPa) stehen kann, müssen an solche Quarz-Metall-Verbindungen hohe, insbesondere vakuumtechnische Anforderungen gestellt werden, die zu aufwendigen und teuren Verbindungen führen.

In dem Fachbuch "Theorie und Praxis der Vakuumtechnik" von Wutz, Adam, Walcher, Vieweg und Sohn, Braunschweig, Aufl. 1982, S. 478-479 ist eine Verbindung eines Glasrohres mit einem Metallrohr offenbart. Das Glasrohr ist an einem Ende in das Metallrohr eingesteckt und mittels einer das Glasrohr umfassenden Schraube mit dem Metallrohr verbunden. Zwei O-Ringe dienen der Abdichtung. Allerdings ist diese Verbindung nur zum Anschließen von Vakuummeßröhren aus Glas an Metallapparaturen geeignet. Bei Temperaturen von 500°C bis 800°C und einem sehr niedrigen Unterdruck in dem Glasrohr dichtet diese Verbindung nicht mehr zuverlässig ab. Darüber hinaus sind keine Vorkehrungen getroffen, zu verhindern, daß das Glasrohr bei starker Erwärmung mit dem Metallrohr in Berührung treten kann.

Auf S. 478 desselben Fachbuchs ist eine Flanschverbindung zwischen zwei Rohren offenbart, die eine Doppeldichtung mit einem Zwischenkanal verwendet, der evakuierbar ist. Dazu verlaufen zwischen den Flanschen zwei Ringkammern, in denen jeweils ein O-Ring eingelegt ist. Zwischen den O-Ringen verläuft der evakuierbare Zwischenkanal.

Der Erfindung liegt die Aufgabe zugrunde, eine Vorrichtung zum Verbinden von zwei Körpern unterschiedlicher Materialien bereitzustellen, die aus wenigen Komponenten besteht, leicht montier- und demontierbar ist und auch bei großen Temperaturunterschieden und sehr niedrigen Drücken eine große Dichtfähigkeit besitzt.

Die Erfindung löst dieses technische Problem durch die Merkmale des Anspruchs 1.

Die erfindungsgemäße Vorrichtung ist zum vakuumdichten Verbinden von zwei Körpern unterschiedlicher Materialien, insbesondere eines Quarz- und eines Metallkörpers, ausgebildet, die jeweils einen im wesentlichen rohrförmigen Endabschnitt aufweisen, wobei im verbundenen Zustand der rohrförmige Endabschnitt des ersten Körpers den Endabschnitt des zweiten Körpers wenigstens teilweise umgibt. Ferner ist wenigstens ein Zwischenkanal zwischen den rohrförmigen Endabschnitten ausgebildet, der von zwei Dichtringen abgedichtet ist. Der Zwischenkanal ist mit einer Absaugeinrichtung verbunden, die das von den Dichtringen durchgelassene Gas aus dem Zwischenkanal abführt.

Um eine bessere Dichtwirkung zu erzielen, verläuft wenigstens eine erste Druckeinrichtung (90) im verbundenen Zustand wenigstens teilweise zwischen den beiden rohrförmigen Endabschnitten, wobei eine der beiden Dichtringe im verbundenen Zustand zwischen den rohrförmigen Endabschnitten und der Druckeinrichtung eingequetscht ist. Ein erster nachgiebiger Abstandshalter ist zwischen der ersten Druckeinrichtung und dem Endabschnitt des zweiten Körpers angeordnet, um zu verhindern, daß die beiden Körper sich bei stark unterschiedlichen Temperaturen berühren. Radiale Ausdehnungen der beiden Endabschnitte werden somit von dem nachgiebigen Abstandshalter kompensiert.

Gemäß einer Weiterbildung der Erfindung bildet eine Aussparung in der ersten Druckeinrichtung den Zwischenkanal.

Eine alternative Ausführungsform enthält anstelle des Zwischenkanals eine erste Druckeinrichtung, die im verbundenen Zustand wenigstens teilweise zwischen den beiden rohrförmigen Endabschnitten verläuft. Eine erste Dichtung ist derart angeordnet, daß sie im verbundenen Zustand zwischen den rohrförmigen Endabschnitten und der Druckeinrichtung eingequetscht ist. Ein erster nachgiebiger Abstandshalter ist zwischen der ersten Druckeinrichtung und dem Endabschnitt des zweiten Körpers angeordnet.

Vorteilhafte Weiterbildungen der Erfindung sind in den Unteransprüchen beschrieben.

Um die geforderte Dichtfähigkeit der Verbindung zu erzielen, ist eine zweite Druckeinrichtung vorgesehen, die im verbundenen Zustand wenigstens teilweise zwischen der ersten Druckeinrichtung und dem Endabschnitt des zweiten Körpers verläuft und die die zweite Dichtung im Zusammenspiel mit der ersten Druckeinrichtung sowie dem Endabschnitt des zweiten Körpers einquetscht. Auf diese Weise ist sowohl die erste als auch die zweite Dichtung bezüglich der zu verbindenden rohrförmigen Endabschnitte einquetschbar, wodurch die angestrebte Abdichtfähigkeit erzielt wird.

Damit sichergestellt ist, daß der zweite Körper nicht mit den Druckeinrichtungen und dem ersten Körper in Verbindung treten kann, ist ein zweiter nachgiebiger Abstandshalter zwischen dem Endabschnitt des zweiten Körpers und der zweiten Drukkeinrichtung angeordnet.

Zweckmäßigerweise sind die Abstandshalter jeweils in einer entsprechenden ringförmigen Ausnehmung der jeweiligen Druckeinrichtung eingelegt. Eine dritte Dichtung, die zwischen der ersten Druckeinrichtung und dem Endabschnitt des ersten Körpers angeordnet ist, verbessert weiter die Dichtfähigkeit der Verbindungsvorrichtung :

Als Material für die Abstandshalter kann z. B. Polytetrafluoräthylen verwendet werden.

Eine besonders einfache Montage und Demontage der Verbindungsvorrichtung wird dadurch erreicht, daß die erste und zweite Druckeinrichtung im wesentlichen L-förmig ausgebildet sind, wobei der erste Schenkel der ersten Druckeinrichtung wenigstens teilweise zwischen den Endabschnitten der zu verbindenden Körper verläuft und der zweite Schenkel die Stirnfläche des Endabschnitts des ersten Körpers wenigstens teilweise umgibt, und wobei der erste Schenkel der zweiten Druckeinrichtung wenigstens teilweise zwischen dem ersten Schenkel der ersten Druckeinrichtung und dem Endabschnitt des zweiten Körpers verläuft und der zweite Schenkel der zweiten Druckeinrichtung wenigstens teilweise den zweiten Schenkel der ersten Druckeinrichtung umgibt.

Zweckmäßigerweise sind die erste und/oder zweite Druckeinrichtung mit dem ersten Körper verschraubbar. Als Dichtungen werden zweckmäßigerweise O-Ringe verwendet.

Die erfindungsgemäße Verbindungsvorrichtung ist insbesondere für eine Epitaxieanlage mit einem unter niedrigem Druck stehenden und hohen Temperaturen ausgesetzten Quarzrohr, das insbesondere zur Aufnahme von zu beschichtenden Mafern dient, geeignet.

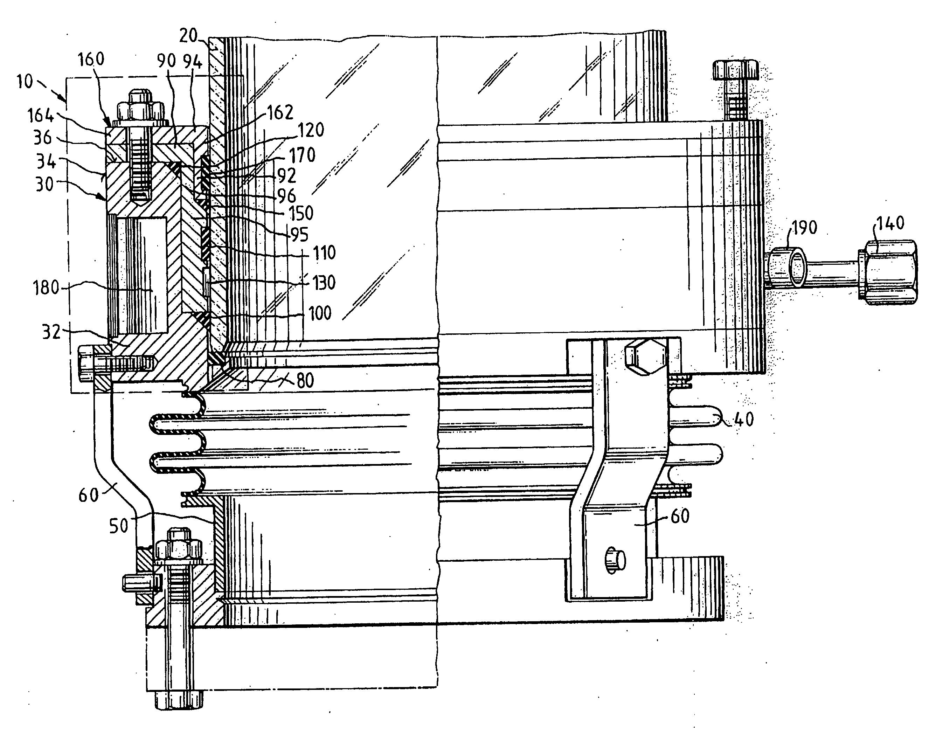

Die Erfindung wird nachstehend anhand eines Ausführungsbeispiels in Verbindung mit der beiliegenden Zeichnung näher erläutert.

Die erfindungsgemäße Verbindungsvorrichtung kann als Quetschverbindung angesehen werden, die in der Figur allgemein mit 10 bezeichnet ist. Die Figur zeigt im Querschnitt die Quetschverbindung 10, wie sie z. B. in einer nicht dargestellten Epitaxieanlage, beispielsweise zur Beschichtung von Wafern, verwendet werden kann. In solchen Epitaxieanlagen wird beispielsweise ein Quarzrohr verwendet, von dem lediglich der rohrförmige Endabschnitt 20 dargestellt ist. Das Quarzrohr ist an einer Seite beispielsweise mit einer vakuumdicht verschließbaren Schleuse abgeschlossen, durch die mit Hilfe eines Quarzbootes zu beschichtende Wafer in das Quarzrohr beschickbar sind. In dem Quarzrohr herrscht ein sehr niedriger Druck von beispielsweise 10⁻¹⁰ hPa. An den rohrförmigen Endabschnitt 20 ist das Quarzrohr mit einem metallischen Gehäuse 30 vakuumdicht verbunden. Um durch hohe Temperaturen in dem Quarzrohr, die zwischen 500 und 800°C liegen können, verursachte Längsausdehnungen des Quarzrohres aufnehmen zu können, ist der rohrförmige Endabschnitt 20 des Quarzrohres mit einem Faltenbalg 40 abgeschlossen, der das Quarzrohr beispielsweise mit einer Ultrahochvakuumpumpeneinheit über einen Rohransatz mit einem Flansch 50 verbinden. Damit der Faltenbalg 40 frei von Querkräften ist, ist das Gehäuse 30 über mehrere Laschen 60 an dem Gehäuseflansch 50 der Epitaxieanlage befestigt. Wie die Figur zeigt, liegt der rohrförmige Endabschnitt 20 über einen Anschlagrings 80 an dem Faltenbalg 40 auf. Bei dem Anschlagring handelt es sich beispielsweise um einen PTFE- (Polytetrafluoräthylen-) Ring.

Der rohrförmige Endabschnitt 20 des Quarzrohres ist, wie die Figur zeigt, in einen metallischen Rohransatz 30 eingesteckt. Der metallische Rohransatz 30 weist im wesentlichen einen L-förmigen Querschnitt auf, wobei der quer zum Endabschnitt 20 verlaufende Schenkel 32 des Rohransatzes 30 in einem geringeren Abstand zum Endabschnitt 20 angeordnet ist als der parallel zum Endabschnitt 20 verlaufende Schenkel 34. Der Schenkel 32 des Rohransatzes 30 erstreckt sich über den rohrförmigen Endabschnitt 20 hinaus und bildet einen Kragen, innerhalb dessen der Endabschnitt des Faltenbalgs 40 einliegt. Der längliche Schenkel 34 ist an seiner Stirnfläche 36 flanschartig verbreitert und bildet mit dem Schenkel 32 eine Ringnut, in der eine ringförmige Wasserkammer 180 angeordnet ist, die mit einem Kühlwasseranschluß 190 zur Kühlung der Quetschverbindung 10 verbunden ist. Ein derster, im wesentlichen L-förmiger Druckring 90, beispielsweise aus Stahl, ist zwischen dem rohrförmigen Endabschnitt 20 und dem Schenkel 34 des metallischen Rohransatz 30 eingesetzt. Der Druckring 90 weist im wesent lichen einen längeren, parallel zum Endabschnitt 20 verlaufenden Schenkel 92 auf, der sich bis zum unteren Schenkel 32 des Rohransatzes 30 erstreckt und auf diesem aufsitzt. Der Schenkel 32 des Ansatzrohres 30 ist beispielsweise in Richtung des rohrförmigen Endabschnitts 20 derart abgeschrägt, daß er zusammen mit dem Endabschnitt 20 beispielsweise eine keilförmige Umlaufnut bildet, in die ein O-Ring 100 eingesetzt ist. Im verbundenen Zustand preßt der Schenkel 92 des Druckrings 90 den O-Ring 100 in die keilförmige Umlaufnut ein. Damit bei stark unterschiedlichen Temperaturen das Quarzrohr nicht mit dem Druckring 90 in Berührung treten kann und möglicherweise zerbricht, ist in den Schenkel 92 des Druckrings 90 eine ringförmige Aussparung ausgenommen, in die ein nachgiebiger Abstandshalter 110 eingelegt ist. Auch der Abstandshalter 110 kann aus Polytetrafluoräthylen bestehen. Der Druckring 90 weist ferner einen senkrecht zum rohrförmigen Endabschnitt 20 verlaufenden Schenkel 94 auf, der in diesem Beispiel vollständig die flanschartige Stirnseite 36 des metallischen Rohransatzes 30 abdeckt. Der flanschartige Schenkel 34 ist an der zum rohrförmigen Endabschnitt 20 weisenden Richtung abgeschrägt und bildet im verbundenen Zustand mit den beiden aneinanderstoßenden Schenkeln 94 und 92 des Druckrings 90 einen Preßsitz für einen weiteren Dichtring 120. Um die Dichtfähigkeit der erfindungsgemäßen Quetschverbindung 10 zu verbessern, ist in den Schenkel 92 des Druckrings 90 eine weitere ringförmige Aussparung vorgesehen, die einen sogenannten Zwischenkanal 130 bildet, der von dem rohrförmigen Endabschnitt 20 begrenzt wird. Der Zwischenkanal 130 ist über einen Stutzen 140 mit einer nicht dargestellten Absaugeinrichtung verbunden, die zum einen die aus dem Quarzrohr in den Zwischenkanal 130 entweichenden Gase und zum anderen die über die Dichtung 150 eintretenden Gase absaugt. Hierbei hat der Zwischenkanal 130 die Funktion einer Druckstufe zur Erzielung eines UHV-Drucks im Quarzrohr. Der Zwischenkanal 130 wird zum einen durch die Dichtung 100 und zum anderen durch eine Dichtung 150 abgedichtet. Wie in der Figur dargestellt ist, weist der längliche Schenkel 92 des Druckrings 90 ein stufenartiges Profil parallel zur Längsachse des Quarzrohres auf, das beginnend vom Schenkel 94 einen ersten Abschnitt 96 aufweist, dessen Innendurchmesser größer ist als der Innendurchmesser des sich daran anschließenden Abschnitts 95. Der Abschnitt 95 bildet deshalb einen stufenartigen Vorsprung mit Bezug auf den Abschnitt 96, der im wesentlichen sich bis zum Endabschnitt 20 erstreckt, diesen aber nicht berührt. Der Schenkelabschnitt 95 ist derart abgeschrägt, daß er zusammen mit dem rohrförmigen Endabschnitt 20 eine im wesentlichen keilförmige Umlaufnut bildet, in die ein O-Ring 150 eingelegt ist. Ein weiterer Druckring 160 ist in den Freiraum zwischen dem Abschnitt 96 des Schenkels 92 des Druckrings 90 und dem rohrförmigen Endabschnitt 20 eingesetzt. Der Druckring 160 ist ebenfalls L-förmig ausgebildet, wobei der kürzere, parallel zum Endabschnitt 20 verlaufende Schenkel 162 zwischen dem Abschnitt 96 des Schenkels 92 und dem Endabschnitt 20 angeordnet ist, wohingegen der längere Schenkel 164 des Druckrings 160 vollständig den Schenkel 94 des Druckrings 90 abdeckt. Um zu vermeiden, daß bei extrem unterschiedlichen Temperaturen der glasförmige Endabschnitt 20 mit dem Druckring 160 in Berührung kommt, ist in dem Schenkel 162 eine Ringnut ausgenommen, in der ein weiterer nachgiebiger Abstandshalter 170 eingelegt ist. Zueinander fluchtende Bohrungen sind in den Schenkel 164 des Druckrings 160, den Schenkel 94 des Druckrings 90 und in den flanschförmigen Schenkel 34 des Metallgehäuses 30 ausgenommen. Mittels Schrauben, die durch diese Bohrungen führen, kann die Quetschverbindung 10 schnell und einfach montiert und demontiert werden.

Dank der Erfindung ist es möglich, mit wenigen und einfach geformten Komponenten eine Quetschverbindung bereitzustellen, die bei großen Temperaturunterschieden (zwischen 500°C und 800°C) und extrem niedrigen Drücken (z. B. 10⁻¹⁰ hPa) eine hohe und zuverlässige Dichtfähigkeit aufweist. Dazu sind beispielsweise lediglich die beiden im wesentlichen L-förmigen Druckringe aus Stahl 90,160 vorgesehen, die im zusammengesetzten Zustand die zwischen Druckringen und Rohr angeordneten Dichtungen 100, 150 und 120 gegen das Gehäuse 30 verquetschen and somit eine hohe Abdichtung gewährleisten. Darüber hinaus ist in dem Druckring 90 ein Zwischenkanal 130 ausgenommen, an den die Absaugeinrichtung angeschlossen ist, um ausströmende Gase absaugen zu können.

### Bezugszeichenliste

- 10: Quetschverbindung
- 20: Endabschnitt
- 30: Endabschnitt
- 32: Schenkel
- 34: Schenkel
- 36: Schenkelstirnfläche
- 40: Faltenbalg
- 50: Flansch, Gehäuseflansch
- 60: Lasche
- 80: Anschlagring
- 90: Druckeinrichtung
- 92: Schenkel
- 94: Schenkel
- 95: Schenkelabschnitt
- 96: Schenkelabschnitt
- 100: O-Ring, Dichtung
- 110: Abstandshalter
- 120: Dichtring
- 130: Zwischenkanal
- 140: Stutzen
- 150: O-Ring, Dichtung
- 160: Druckeinrichtung
- 162: Schenkel
- 164: Schenkel
- 170: Abstandshalter
- 180: Wasserkammer
- 190: Kühlwasseranschluß

## Patentansprüche

1. Vorrichtung zum vakuumdichten Verbinden von zwei Körpern, deren Materialien unterschiedlich sind, die jeweils einen im wesentlichen rohrförmigen Endabschnitt (20,30) aufweisen, wobei im verbundenen Zustand der rohrförmige Endabschnitt (30) des ersten Körpers den Endabschnitt (20) des zweiten Körpers wenigstens teilweise umgibt, **gekennzeichnet durch** eine Temperaturbeständigkeit von 500-800°C für dass Material eines der Körper und einen Zwischenkanal (30), der zwischen den rohrförmigen Endabschnitten (20, 30) ausgebildet ist, und **durch** zwei Dichtungen (100, 150), die den Zwischenkanal (130) abdichten.

2. Vorrichtung nach Anspruch 1, **dadurch gekennzeichnet, dass** wenigstens eine erste Druckeinrichtung (90) im verbundenen Zustand wenigstens teilweise zwischen den beiden rohrförmigen Endabschnitten (20, 30) verläuft, dass die erste Dichtung (100) im verbundenen Zustand zwischen den rohrförmigen Endabschnitten (20, 30) und der Druckeinrichtung (90) eingequetscht ist, und dass ein erster nachgiebiger Abstandshalter (110) zwischen der ersten Druckeinrichtung (96) und dem Endabschnitt (20) des zweiten Körpers angeordnet ist.

3. Vorrichtung nach Anspruch 1 oder 2, **dadufch gekennzeichnet**, dass eine Aussparung in der ersten Druckeinrichtung (90) den Zwischenkanal (130) bilet.

4. Vorrichtung zum vakuumdichten Verbinden von zwei Körpern, deren Materialien unterschiedlich sind, die jeweils einen im wesentlichen rohrförmigen Endabschnitt (20, 30) aufweisen, wobei im verbundenen Zustand der rohrförmige Endabschnitt (30) des ersten Körpers den Endabschnitt (20) des zweiten Körpers wenigstens teilweise umgibt, **gekennzeichnet durch** eine Temperaturbeständigkeit von 500-800°C für das Material eines der Körper und wenigstens eine erste Druckeinrichtung (90), die im verbundenen Zustand wenigstens teilweise zwischen den beiden rohrförmigen Endabschnitten (20, 30) verläuft, eine erste Dichtung (100), die im verbundenen Zustand zwischen den rohrförmigen Endabschnitten (20, 30) und der Druckeinrichtung (90) eingequetscht ist, und einen ersten nachgiebigen Abstandshalter (110), der zwischen der ersten Druckeinrichtung (90) und dem Endabschhnitt (20) des zweiten Körpers angeordnet ist.

5. Vorrichtung nach einem der Ansprüche 2 bis 4, **gekennzeichnet durch** eine zweite Druckeinrichtung (160), die im verbundenen Zustand wenigstens teilweise zwischen der ersten Druckeinrichtung (90) und dem Endabschnitt (20) des zweiten Körpers verläuft und die zweite Dichtung (150 ) im Zusammenspiel mit der ersten Druckeinrichtung (90) sowie dern Endabschnitt (20) des zweiten Körpers einquetscht.

6. Vorrichtung nach Anspruch 5, **gekennzeichnet durch** einen zweiten nachgiebigen Abstandshalter (170), der zwischen dem Endabschnitt (20) des zweiten Körpers und der zweiten Druckeinrichtung (160) angeordnet ist.

7. Vorrichtung nach einem der Ansprüche 2 bis 6, **gekennzeichnet durch** eine dritte Dichtung (120), die zwischen der ersten Druckeinrichtung (90) und dem Endabschnitt (30,34) des ersten Körpers angeordnet ist.

8. Vorrichtung nach einem der Anspruche 2 bis 7, **dadurch gekennzeichnet, dass** die Abstandhalter aus Polytetrafluoräthylen hergestellt sind.

9. Vorrichtung nach einem der Ansprüche 2 bis 8, **dadurch gekennzeichnet, dass** die erste und zweite Druckeinrichtung (90, 160) im wesentlichen L-förmig ausgebildet sind, wobei der erste Schenkel (92) der ersten Druckeinrichtung (90) wenigstens teilweise zwischen den Endabschnitten (20, 30) der zu verbindenden Körper verläuft und der zweite Schenkel (94) die Stirnfläche (34) des Endabschnitts (30) des ersten Körpers wenigstens teilweise umgibt, und wobei der erste Schenkel (162) der zweiten Druckeinrichtung (160) wenigstens teilweise zwischen dem ersten Schenkel (92) der ersten Druckeinnchtung (90) und dem Endabschnitt (20) des zweiten Körpers verläuft und der zweite Schenkel (164) der zweiten Druckeinrichtung (160) wenigstens teilweise den zweiten Schenkel (94) der ersten Druckeinrichung (90) umgibt.

10. Vorrichtung nach einem der Ansprüche 2 bis 9, **dadurch gekennzeichnet**, dann die erste und/oder zweite Druckeinrichtung mit dem ersten Körper verschraubbar ist, und dass die Dichtungen O-Ringe sind.

11. Epitaxieanlage mit einem Quarzrohr insbesondere zur Aufnahme von zu beschichtenden Wafern, die mittels einer Vorrichtung nach einem der Ansprüche 1 bis 10 mit einem Metallgehäuse verbindbar ist.

12. Epitaxieanlage nach Anspruch 11, **gekennzeichnet durch** einen den rohrförmigen Endabschnitt des Quarzrohres abschließenden Faltenbalg zur Aufnahme von Längsausdehnungen des Quarzrohres, wobei ein im wesentlichen ringförmiges Anschlagelement zwischen dem Metallgehäuse, dem Endabschnitt der Quarzröhre und dem Faltenbalg angeordnet ist.

13. Vorrichtung nach mindestens einem der Ansprüche 1 bis 10, **dadurch gekennzeichnet, dass** der Zwischenkanal mit einer Absaugeinrichtung verbunden ist, über die das von den Dichtringen (100,150) durchgelassene Gas aus dem Zwischenkanal (130) abführbar ist.

14. Epitaxieanlage nach Anspruch 11 oder 12, **dadurch gekennzeichnet, dass** der Zwischenkanal mit einer Absaugeinrichtung verbunden ist, über die das von den Dichtringen (100,150) durchgelassene Gas aus dem Zwischenkanal (130) abführbar ist.

15. Vorrichtung nach Anspruch 1 oder 4, **dadurch gekennzeichnet, dass** der erste Körper aus Metall und der zweite Körper aus Quarz besteht.

## Claims

1. Device for the vacuum-tight connection of two bodies of different materials, each of which has an essentially tubular end section (20, 30), where in the connected state the tubular end section (30) of the first body at least partially surrounds the end section (20) of the second body, **characterised by** a temperature resistance of 500 - 800°C for the material of one of the bodies and an intermediate channel (130) formed between the tubular end sections (20, 30), and by two seals (100, 150) which seal the intermediate channel (130).

2. Device according to claim 1, **characterised in that**,at least one first pressure device (90) in the connected state runs at least partially between the two tubular end sections (20, 30), that in the connected state the first seal (100) is squeezed between the tubular end sections (20, 30) and the pressure device (90) and that a first flexible spacer (110) is arranged between the first pressure device (90) and the end section (20) of the second body.

3. Device according to claim 1 or 2, **characterised in that** a recess in the first pressure device (90) forms the intermediate channel (130).

4. Device for the vacuum-tight connection of two bodies of different materials, each of which has an essentially tubular end section (20, 30), where in the connected state the tubular end section (30) of the first body at least partially surrounds the end section (20) of the second body, **characterised by** a temperature resistance of 500 - 800°C for the material of one of the bodies and at least one first pressure device (90) which in the connected state runs at least partially between the two tubular end sections (20, 30), a first seal (100) which in the connected state is squeezed between the tubular end sections (20, 30) and the pressure device (90), and a first flexible spacer (110) which is arranged between the first pressure device (90) and the end section (20) of the second body.

5. Device according to any of claims 2 to 4, **characterised by** a second pressure device (160) which in the connected state runs at least partially between the first pressure device (90) and the end section (20) of the second body, and squeezes the second seal (150) in co-operation with the first pressure device (90) and the end section (20) of the second body.

6. Device according to claim 5, **characterised by** a second flexible spacer (170) which is arranged between the end section (20) of the second body and the second pressure device (160).

7. Device according to any of claims 2 to 6, **characterised by** a third seal (120) which is arranged between the first pressure device (90) and the end section (30, 34) of the first body.

8. Device according to any of claims 2 to 7, **characterised in that** the spacers are made from polytetrafluoroethylene.

9. Device according to any of claims 2 to 8, **characterised in that** the first and second pressure devices (90, 160) are essentially L-shaped, where the first leg (92) of the first pressure device (90) runs at least partially between the end sections (20, 30) of the bodies to be connected and the second leg (94) at least partially surrounds the front face (34) of the end section (30) of the first body, and where the first leg (162) of the second pressure device (160) runs at least partially between the first leg (92) of the first pressure device (90) and the end section (20) of the second body and the second leg (164) of the second pressure device (160) at least partially surrounds the second leg (94) of the first pressure device (90).

10. Device according to any of claims 2 to 9, **characterised in that** the first and/or second pressure device can be screwed to the first body and that the seals are O-rings.

11. Epitaxial system with a quartz tube, in particular to receive wafers to be coated, which can be connected with a metallic housing by means of a device according to any of claims 1 to 10.

12. Epitaxial system according to claim 11, **characterised by** a bellows closing the tubular end section of the quartz tube, to absorb longitudinal expansions of the quartz tube, where an essentially annular stop element is arranged between the metallic housing, the end section of the quartz tube and the bellows.

13. Device according to any of claims 1 to 10, **characterised in that** the intermediate channel is connected with a suction device via which the gas passing by the sealing rings (100, 150) can be extracted from the intermediate channel (130).

14. Epitaxial system according to claim 11 or 12, **characterised in that** the intermediate channel is connected with a suction device via which the gas passing by the sealing rings (100, 150) can be extracted from the intermediate channel (130).

15. Device according to claim 1 or 4, **characterised in that** the first body comprises metal and the second body quartz.

## Revendications

1. Dispositif de liaison étanche au vide entre deux corps de matières différentes qui comportent chacun une portion d'extrémité sensiblement tubulaire (20, 30), lorsqu'elles sont reliées, la portion d'extrémité tubulaire (30) du premier corps entoure au moins partiellement la portion d'extrémité (20) du deuxième corps, **caractérisée par** une résistance à une température comprise entre 500 et 800°C pour la matière de l'un des corps et pour un canal intermédiaire (130), qui est conformé entre les portions d'extrémité tubulaires (20, 30) et par deux garnitures d'étanchéité (100, 150) qui réalisent l'étanchéité au niveau du canal intermédiaire (130).

2. Dispositif selon la revendication 1, **caractérisé en ce que** au moins un premier dispositif de compression (90) s'étend à l'état relié au moins partiellement entre les deux portions d'extrémité tubulaires (20, 30), **en ce que** la première garniture d'étanchéité (100) est serrée à l'état relié entre les portions d'extrémité tubulaires (20, 30) et le dispositif de compression (90), et **en ce qu'**un premier dispositif d'espacement flexible (110) est disposé entre le premier dispositif de compression (90) et la portion d'extrémité (20) du deuxième corps.

3. Dispositif sur la revendication 1 ou 2, **caractérisé en ce qu'**un évidement forme le canal intermédiaire (130) dans le premier dispositif de pression (90).

4. Dispositif de liaison étanche au vide de deux corps de matières différentes qui comportent chacun une portion d'extrémité sensiblement tubulaire (20, 30), lorsqu'elles sont reliées, la portion d'extrémité tubulaire (30) du premier corps entoure au moins partiellement la portion d'extrémité (20) du deuxième corps, **caractérisé par** une résistance à une température comprise entre 500 et 800°C pour la matière de l'un des corps, et par au moins un premier dispositif de compression (90) qui s'étend au moins partiellement entre les deux portions d'extrémité tubulaires (20, 30) à l'état relié, une première garniture d'étanchéité (100) qui est serrée à l'état relié entre les portions d'extrémité tubulaires (20, 30) et le dispositif de compression (90), et un dispositif d'espacement flexible (110) qui est disposé entre le premier dispositif de compression (90) et la portion d'extrémité (20) du deuxième corps.

5. Dispositif selon l'une des revendications 2 à 4, **caractérisé par** un deuxième dispositif de compression (160) qui s'étend à l'état relié au moins partiellement entre le premier dispositif de compression (90) et la première portion d'extrémité (20) du deuxième corps et serre la deuxième garniture étanchéité (150) en coopération avec le premier dispositif de compression (90) ainsi que la portion d'extrémité (20) du deuxième corps.

6. Dispositif selon la revendication 5, **caractérisé par** un deuxième dispositif flexible d'espacement (170) qui est disposé entre la portion d'extrémité (20) du deuxième corps et le deuxième dispositif de compression (160).

7. Dispositif selon l'une des revendications 2 à 6, **caractérisé par** une troisième garniture d'étanchéité (120) qui est disposée entre le premier dispositif de compression (90) et la portion d'extrémité (30, 34) du premier corps.

8. Dispositif selon l'une des revendications 2 à 7, **caractérisé en ce que** les dispositifs d'espacement sont en polytétrafluoréthylène.

9. Dispositif selon l'une des revendications 2 à 8, **caractérisé ce que** les premier et deuxième dispositifs de compression (90, 160) sont conformés sensiblement en L, la première branche (92) du premier dispositif de compression (90) s'étend au moins partiellement entre les portions d'extrémité (20, 30) du corps à relier et la deuxième branche (94) entoure au moins partiellement la face frontale (34) de la portion d'extrémité (30) du premier corps, et la première branche (162) du deuxième dispositif de compression (160) s'étend au moins partiellement entre la première branche (92) du premier dispositif de compression (90), et la portion d'extrémité (20) du deuxième corps et la deuxième branche (175) du deuxième dispositif de compression (164) entoure au moins partiellement la deuxième branche (94) du premier dispositif de compression (90).

10. Dispositif selon l'une des revendications 2 à 9, **caractérisé en ce que** le premier et/ou le deuxième dispositif de compression peuvent être vissés au premier corps et **en ce que** les garnitures d'étanchéité sont des joints toriques.

11. Installation d'épitaxie comportant un tube de quartz destiné en particulier à recevoir des plaquettes à revêtir, laquelle installation d'épitaxie peut être reliée à un boîtier métallique au moyen d'un dispositif selon l'une des revendications 1 à 10.

12. Installation d'épitaxie selon la revendication 11, **caractérisée par** un soufflet terminant la portion d'extrémité tubulaire du tube de quartz et destiné à recevoir des prolongements longitudinaux du tube de quartz ; un élément de butée sensiblement annulaire étant disposé entre le boîtier métallique, la portion d'extrémité du tube de quartz et le soufflet.

13. Dispositif selon au moins l'une des revendications 1 à 10, **caractérisé en ce que** le canal intermédiaire est relié à un dispositif d'aspiration permettant d'évacuer du canal intermédiaire (130) le gaz que laissent passer les bagues d'étanchéité (100, 150).

14. Installation d'épitaxie selon la revendication 11 ou 12, **caractérisée en ce que** le canal intermédiaire est relié à un dispositif d'aspiration permettant d'évacuer du canal intermédiaire (130) le gaz que laissent passer les bagues d'étanchéité (100, 150).

15. Dispositif selon la revendication 1 ou 4, **caractérisé en ce que** le premier corps est en métal et **en ce que** le deuxième corps est en quartz.
